# EUROPEAN PATENT APPLICATION

(11) **EP 4 664 525 A1**
(43) Date of publication of application: **17.12.2025**
(21) Application number: 23926102.7
(22) Date of filing: 20.12.2023
(51) Int. Cl.: H01L 23/538, H01L 23/498, H01L 21/48

(54) **BRIDGE DIE, DIE PACKAGING STRUCTURE, MANUFACTURING METHOD FOR BRIDGE DIE, AND ELECTRONIC DEVICE**

(30) Priority: 06.03.2023 CN 202310254321
(71) Applicant: Huawei Technologies Co., Ltd., Shenzhen, Guangdong 518129 (CN)
(72) Inventor: ZHANG, Tonglong, Shenzhen, Guangdong 518129 (CN); LIU, Siyan, Shenzhen, Guangdong 518129 (CN); WU, Shenghao, Shenzhen, Guangdong 518129 (CN); LI, Heng, Shenzhen, Guangdong 518129 (CN); LUO, Wei, Shenzhen, Guangdong 518129 (CN)
(74) Representative: Goddar, Heinz J.
(86) International application number: PCT/CN2023/140243
(87) International publication number: WO 2024/183408

(57) **Abstract**

This application provides a bridge die, a chip package structure, a manufacturing method, and an electronic device, and relates to the field of semiconductor technologies, to increase an overall coefficient of thermal expansion of the bridge die. The bridge die includes a first molding layer, a metal routing layer, and at least two die connection regions. A plurality of through molding vias TMVs (through molding vias) are disposed in the first molding layer, the metal routing layer is disposed on the first molding layer, and the metal routing layer is electrically connected to the plurality of TMVs. The at least two die connection regions are located on a side that is of the metal routing layer and that is away from the first molding layer, a plurality of first metal connection structures are disposed in each die connection region, and the plurality of first metal connection structures are electrically connected to the metal routing layer. In this application, the first molding layer is disposed in the bridge die to increase the overall coefficient of thermal expansion of the bridge die, thereby reducing a stress generated between the bridge die and a surrounding package structure due to thermal mismatch.

## Description

This application claims priority to Chinese Patent Application No. 202310254321.3, filed with the China National Intellectual Property Administration on March 6, 2023 and entitled "BRIDGE DIE, CHIP PACKAGE STRUCTURE, MANUFACTURING METHOD, AND ELECTRONIC DEVICE", which is incorporated herein by reference in its entirety.

### TECHNICAL FIELD

This application relates to the field of semiconductor technologies, and in particular, to a bridge die, a chip package structure, a manufacturing method, and an electronic device.

### BACKGROUND

As people have increasingly high requirements on chip performance, a 2.5D/3D package technology has become a hot topic in the semiconductor industry in recent years. In the 2.5D/3D package technology, a form of chiplets (chiplets) is used, and a plurality of dies (dies) are packaged together. This has advantages such as a small package size, low power consumption, and a small quantity of pins.

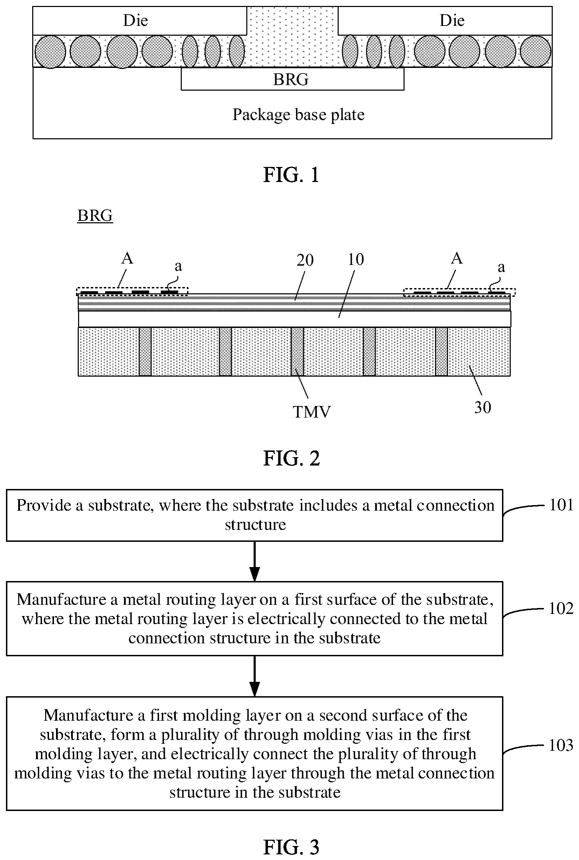

For example, as shown in FIG. 1, in some 2.5D package structures, based on an actual requirement, a bridge die BRG (bridge die, also referred to as a bridge die) needs to be used as an interconnection structure between different dies, to meet interconnection and communication between the dies. However, an existing bridge die BRG is made of silicon (Si). Because a coefficient of thermal expansion (coefficient of thermal expansion, CTE) of silicon is small, and a coefficient of thermal expansion of a package structure around the bridge die BRG is large, a large stress is generated between the bridge die BRG and the dies due to thermal mismatch, resulting in cracking (crack) of the interconnection structure between the bridge die BRG and the dies.

### SUMMARY

This application provides a bridge die, a chip package structure, a manufacturing method, and an electronic device, to increase an overall coefficient of thermal expansion of the bridge die.

This application provides a bridge die. The bridge die includes a first molding layer, a metal routing layer, and at least two die connection regions. A plurality of TMVs are disposed in the first molding layer, the metal routing layer is disposed on the first molding layer, and the metal routing layer is electrically connected to the plurality of TMVs. The at least two die connection regions are located on a side that is of the metal routing layer and that is away from the first molding layer, a plurality of first metal connection structures are disposed in each die connection region, and the plurality of first metal connection structures are electrically connected to the metal routing layer.

In the bridge die provided in this application, the molding layer (the first molding layer) is disposed at the bottom to form an organic composite structure. Compared with silicon, a mold compound used for the molding layer has a larger coefficient of thermal expansion, to increase an overall coefficient of thermal expansion of the bridge die. When the bridge die is used in a package structure, a stress generated between the bridge die and the surrounding package structure due to thermal mismatch can be reduced. In this way, a probability that an interconnection structure between the bridge die and an interconnected die cracks (crack) is reduced.

In some possible implementations, the first molding layer includes at least one of resin and polyimide.

In some possible implementations, the bridge die further includes a substrate, and the substrate is located between the metal routing layer and the first molding layer. A second metal connection structure is disposed in the substrate, and the metal routing layer is electrically connected to the through molding via through the second metal connection structure.

A bridge die in the conventional technology needs to use a thick substrate, for example, thick silicon of more than 60 µm, to meet a support requirement. In this case, a through silicon via (through silicon via, TSV) with a large depth needs to be disposed on the thick silicon to meet a connection requirement. In contrast, the first molding layer disposed in the bridge die in this application can play a support role, so that a thin substrate (for example, thin silicon of about 20 µm) can be used to meet a requirement. In this way, a TSV with a small depth is combined with a TMV to meet a connection requirement. It may be understood that manufacturing costs of the TSV with the small depth and the TMV are much lower than those of the TSV with the large depth. In this way, costs of the bridge die are reduced.

In some possible implementations, a material of the substrate includes one or more of silicon, glass, silicon nitride, and ceramic.

In some possible implementations, a deep trench capacitor is disposed on a surface of a side that is of the substrate and that is close to the metal routing layer, and the deep trench capacitor is electrically connected to the metal routing layer. A rectification function on a transmitted signal can be implemented through the deep trench capacitor, to improve stability of the transmitted signal.

This application further provides a chip package structure. The chip package structure includes a base plate, a first die, a second die, and the bridge die provided in any one of the foregoing possible implementations. The bridge die is electrically connected to the base plate through a plurality of TMVs. The first die and the second die are located on a side that is of the bridge die and that is away from the base plate, and the first die and the second die are electrically connected to first metal connection structures in two die connection regions respectively.

This application further provides a manufacturing method of a bridge die. The manufacturing method includes: providing a substrate, where a material of the substrate includes a metal connection structure; manufacturing a metal routing layer on a first surface of the substrate, where the metal routing layer is electrically connected to the metal connection structure; and manufacturing a first molding layer on a second surface of the substrate, forming a plurality of through molding vias TMVs in the first molding layer, and electrically connecting the plurality of TMVs to the metal routing layer through the metal connection structure.

This application further provides a manufacturing method of a bridge die. The manufacturing method includes: manufacturing a metal routing layer; and manufacturing a first molding layer on the metal routing layer, forming a plurality of through molding vias TMVs in the first molding layer, and electrically connecting the plurality of TMVs to the metal routing layer.

This application further provides a manufacturing method of a chip package structure. The manufacturing method includes: providing a carrier plate, a first die, and a second die, and disposing active surfaces of the first die and the second die on the carrier plate upwards; providing the bridge die in any one of the foregoing possible implementations, and electrically connecting the first die and the second die to two die connection regions of the bridge die respectively; and molding the first die, the second die, and the bridge die, and exposing a plurality of TMVs and connection structures on the active surfaces of the first die and the second die through grinding.

This application further provides an electronic device. The electronic device includes a circuit board and the foregoing chip package structure. The chip package structure is electrically connected to the circuit board.

### BRIEF DESCRIPTION OF DRAWINGS

FIG. 1 is a diagram of a package structure according to a conventional technology;
FIG. 2 is a diagram of a structure of a bridge die according to an embodiment of this application;
FIG. 3 is a flowchart of a manufacturing method of a bridge die according to an embodiment of this application;
FIG. 4 is a diagram of a manufacturing procedure of a bridge die according to an embodiment of this application;
FIG. 5 is a diagram of a structure of a bridge die according to an embodiment of this application;
FIG. 6 is a flowchart of a manufacturing method of a bridge die according to an embodiment of this application;
FIG. 7 is a diagram of a manufacturing procedure of a bridge die according to an embodiment of this application;
FIG. 8 is a diagram of a chip package structure according to an embodiment of this application;
FIG. 9 is a diagram of a chip package structure according to an embodiment of this application;
FIG. 10 is a flowchart of a manufacturing method of a chip package structure according to an embodiment of this application; and
FIG. 11 is diagram of a manufacturing procedure of a chip package structure according to an embodiment of this application.

### DESCRIPTION OF EMBODIMENTS

To make objectives, technical solutions, and advantages of this application clearer, the following clearly and completely describes technical solutions in this application with reference to accompanying drawings in this application. It is clear that the described embodiments are merely some rather than all of embodiments of this application. All other embodiments obtained by a person of ordinary skill in the art based on embodiments of this application without creative efforts shall fall within the protection scope of this application.

In the specification, embodiments, claims, and accompanying drawings of this application, terms "first", "second", and the like are merely intended for distinguishing and description, and shall not be understood as an indication or implication of relative importance or an indication or implication of a sequence. The term "and/or" is used for describing an association relationship between associated objects, and represents that three relationships may exist. For example, "A and/or B" may represent the following three cases: Only A exists, only B exists, and both A and B exist, where A and B may be singular or plural. The character "/" usually indicates an "or" relationship between the associated objects. "At least one piece (item)" means one or more, and "a plurality of" means two or more. "Installation", "connection", "interconnection", and the like should be understood in a broad sense, for example, may be electrical connection, mechanical connection, fastening, detachable connection, or integrated connection; or may be direct connection, indirect connection through an intermediate medium, or communication between interiors of two elements. In addition, the terms "include", "have", or any variant thereof are intended to cover non-exclusive inclusion, for example, include a series of steps or units. A method, system, product, or device is not necessarily limited to those steps or units expressly listed, but may include another step or unit not expressly listed or inherent to such a process, method, product, or device. "On", "below", "left", "right", and the like are used only relative to orientations of components in the accompanying drawings. These directional terms are relative concepts, are used for relative descriptions and clarifications, and may change accordingly based on changes of positions at which the components in the accompanying drawings are placed.

An embodiment of this application provides an electronic device. The electronic device includes a circuit board (printed circuit board, PCB, which may also be referred to as a printed circuit board) and a chip package structure disposed on the circuit board. In the chip package structure, a new bridge die (bridge die) and at least two dies (dies) are used, and two different dies (dies) are electrically connected to each other through the new bridge die. In other words, the two different dies are interconnected and communicate with each other through the new bridge die.

In the chip package structure provided in this embodiment of this application, the new bridge die uses a composite structure in which a high-density interconnection layer and an organic layer are combined. This can increase an overall coefficient of thermal expansion (CTE) of the bridge die, and reduce a stress generated between the bridge die and a surrounding package structure due to thermal mismatch, thereby reducing a probability that an interconnection structure between the bridge die and the interconnected die cracks (crack), and improving reliability of the chip package structure.

A form in which the electronic device is disposed is not limited in this application. For example, the electronic device may be a mobile phone, a tablet computer, a notebook computer, a vehicle-mounted computer, a smartwatch, a smart band, a server, or another electronic product or component.

The following specifically describes the chip package structure with reference to the new bridge die provided in this embodiment of this application.

First, a structure of the new bridge die provided in this application is described by using specific embodiments.

### Embodiment 1

As shown in FIG. 2, Embodiment 1 provides a bridge die BRG. The bridge die BRG includes a substrate 10, a metal routing layer 20, and a first molding layer 30. The metal routing layer 20 and the first molding layer 30 are disposed on two opposite surfaces of the substrate 10 respectively. For example, the metal routing layer 20 may be disposed on an upper surface of the substrate 10, and the first molding layer 30 is disposed on a lower surface of the substrate 10.

On this basis, as shown in FIG. 2, a plurality of through molding vias TMVs (through molding vias) are disposed in the first molding layer 30. In other words, a plurality of through vias are disposed in the first molding layer 30, and the through vias are filled with a metal material, to form the through molding vias TMVs.

For example, a material for forming the first molding layer 30 may include a thermosetting material like resin (epoxy) or polyimide (polyimide, PI), but this is not limited thereto.

For example, the filling material in the through molding via TMV may include one or more of metal materials such as copper, aluminum, gold, and silver. This is not limited in this application. In practice, a proper material may be selected based on a requirement.

A metal connection structure (which may also be referred to as a second metal connection structure, and is not shown in FIG. 2) is disposed in the substrate 10, and the through molding via TMV is electrically connected to the metal routing layer 20 through the metal connection structure in the substrate 10. For example, the metal connection structure in the substrate 10 may include a metal connection line, a metal through via (for example, a through silicon via), and the like. This is not limited in this application, and may be set based on a requirement in practice.

A material used for the substrate 10 is not limited in this application. For example, in some possible implementations, a material of the substrate 10 may be one or more of materials such as silicon, glass, silicon nitride, and ceramic.

For example, in some possible implementations, the substrate 10 may be a silicon substrate, and the metal connection structure disposed in the silicon substrate may be a through silicon via (through silicon via, TSV). In this case, the through molding via TMV disposed in the first molding layer 30 is electrically connected to the metal routing layer 20 through the through silicon via (TSV) in the silicon substrate.

For example, in some possible implementations, the metal routing layer 20 may be a redistribution layer (redistribution layer, RDL) manufactured by using a back end of line (back end of line, BEOL) in a semiconductor manufacturing process.

In the conventional technology, a main material of a bridge die is silicon, and a coefficient of thermal expansion (2.6 ppm/°C) of the silicon is small. Consequently, a large stress is generated between the bridge die and a surrounding package structure due to thermal mismatch.

The first molding layer 30 is disposed at the bottom of the bridge die BRG provided in Embodiment 1. The first molding layer 30 is made of a mold compound, and the mold compound includes an organic dielectric material like resin (epoxy) or polyimide (polyimide, PI). Compared with the silicon, the mold compound has a larger coefficient of thermal expansion (CTE), and therefore can increase an overall coefficient of thermal expansion of the bridge die. That is, the first molding layer 30 is disposed in the bridge die provided in this embodiment to form an organic composite structure, to increase the overall coefficient of thermal expansion of the bridge die. This can reduce a stress generated between the bridge die and the surrounding package structure due to thermal mismatch, thereby reducing a probability that an interconnection structure between the bridge die and an interconnected die cracks (crack).

In addition, the bridge die in the conventional technology needs to use a thick substrate, for example, thick silicon of more than 60 µm, to meet a support requirement. In this case, a through silicon via (TSV) with a large depth needs to be disposed on the thick silicon to meet a connection requirement. In contrast, the first molding layer 30 disposed in the bridge die provided in Embodiment 1, and the first molding layer 30 can play a support role, so that thin silicon (for example, about 20 µm) can be used to meet a requirement. In this way, a through silicon via (TSV) with a small depth is combined with a through molding via TMV to meet a connection requirement. It may be understood that manufacturing costs of the TSV with the small depth and the through molding via TMV are much lower than those of the TSV with the large depth. In this way, costs of the bridge die BRG are reduced.

Certainly, to meet an interconnection requirement of the bridge die BRG, as shown in FIG. 2, in the bridge die BRG, at least two die connection regions A may be disposed on a surface of a side that is of the metal routing layer 20 and that is away from the first molding layer 30, a metal connection structure a (which may also be referred to as a first metal connection structure) is disposed in each die connection region A, and the metal connection structure a is electrically connected to the metal routing layer 20. In this way, a plurality of dies are electrically connected to metal connection structures a in different die connection regions A, to implement interconnection and communication between the plurality of dies through the metal routing layer 20.

For example, the metal connection structure a disposed in the die connection region A may be a pad (pad), but this is not limited thereto.

In addition, to meet signal stability of the bridge die BRG in an interconnection and communication process, in some possible implementations, a deep trench capacitor (deep trench capacitor, DTC) may be disposed on an upper surface (namely, a surface of a side close to the metal routing layer 20) of the substrate 10, and the deep trench capacitor is electrically connected to the metal routing layer 20, so that a rectification function on a transmitted signal can be implemented through the deep trench capacitor, to improve stability of the transmitted signal.

For example, Embodiment 1 further provides a manufacturing method of the bridge die BRG shown in FIG. 2. As shown in FIG. 3, the manufacturing method may include the following steps.

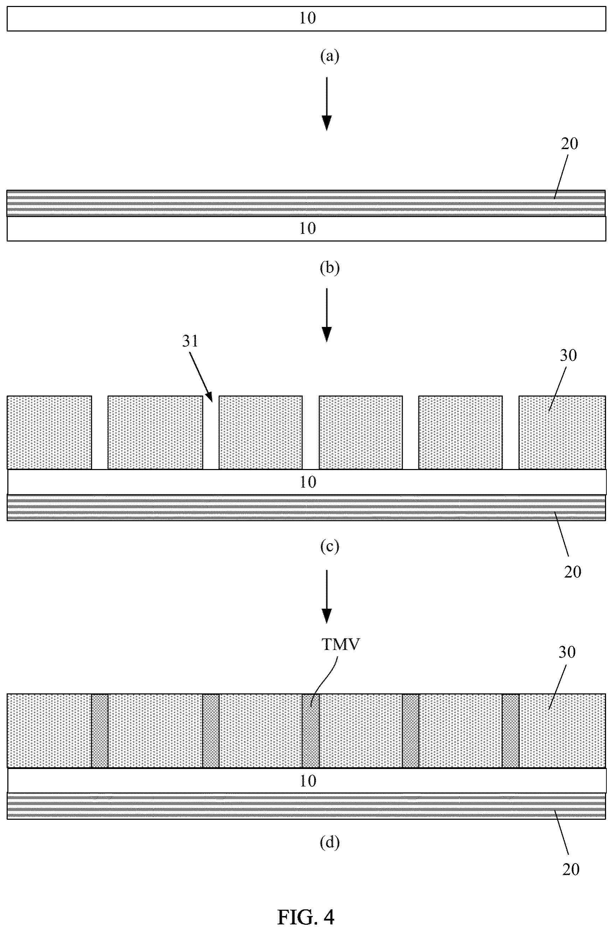

Step 101: Provide the substrate 10 as shown in (a) in FIG. 4, where the substrate 10 includes a metal connection structure.

For example, in some possible implementations, step 101 may include: providing a silicon substrate, and manufacturing a metal connection structure such as a through silicon via in the silicon substrate.

Certainly, based on an actual requirement of the bridge die BRG, a deep trench capacitor (DTC) may be further manufactured on a surface of the substrate 10.

Step 102: Manufacture the metal routing layer 20 on a first surface of the substrate 10 as shown in (b) in FIG. 4, where the metal routing layer 20 is electrically connected to the metal connection structure in the substrate 10.

For example, in some possible implementations, step 102 may include: manufacturing, by using a back end of line (BEOL), a redistribution layer (RDL) on the silicon substrate in which the through silicon via is manufactured, and electrically connecting the redistribution layer (RDL) to the through silicon via (TSV) in the silicon substrate.

Step 103: As shown in (c) and (d) in FIG. 4, manufacture the first molding layer 30 on a second surface (another surface opposite to the first surface) of the substrate 10, form a plurality of through molding vias TMVs in the first molding layer 30, and electrically connect the through molding vias TMVs to the metal routing layer 20 through the metal connection structure in the substrate 10.

For example, in some possible implementations, as shown in (c) in FIG. 4, the first molding layer 30 is formed by using a mold compound (for example, PI) on the another surface that is of the substrate 10 and on which the metal routing layer 20 is not disposed. Then, a plurality of through vias 31 are formed in the first molding layer 30 by using a photolithography process. Next, as shown in (d) in FIG. 4, the plurality of through vias 31 may be filled with copper by using a filling process, to form through molding vias TMVs, and the through molding vias TMVs are electrically connected to the metal routing layer 20 through the metal connection structure in the substrate 10.

Certainly, as shown in FIG. 2, after the redistribution layer (RDL) is manufactured, a plurality of metal connection structures a may be manufactured in a plurality of die connection regions A on a surface of the redistribution layer (RDL) based on an actual process requirement.

### Embodiment 2

Embodiment 2 provides another bridge die BRG. A main difference between the bridge die BRG and the bridge die BRG provided in Embodiment 1 lies in that disposing of a substrate 10 may be omitted.

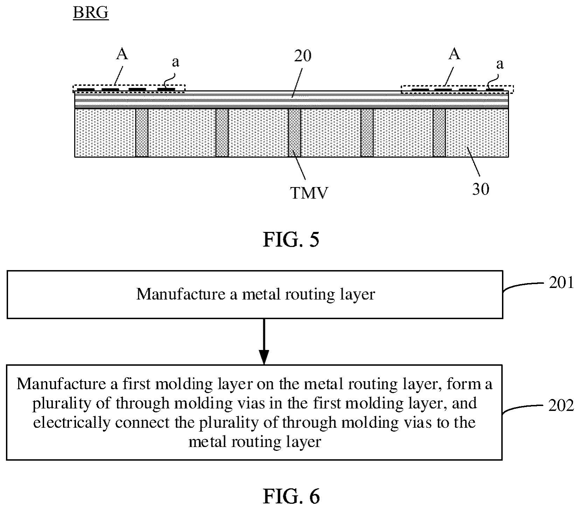

As shown in FIG. 5, in the bridge die BRG provided in Embodiment 2, a metal routing layer 20 is disposed on a first molding layer 30, and a through molding via TMV in the first molding layer 30 is directly electrically connected to the metal routing layer 20. The first molding layer 30 is disposed in the bridge die BRG to form an organic composite structure, to increase an overall coefficient of thermal expansion of the bridge die. This reduces a stress generated between the bridge die and the surrounding structure due to thermal mismatch, thereby reducing a probability that an interconnection structure between the bridge die and an interconnected die cracks (crack).

In addition, compared with the bridge die BRG in Embodiment 1, in the bridge die BRG in Embodiment 2, disposing of the substrate 10 is omitted. This can further reduce costs of the bridge die BRG.

For example, in some possible implementations, compared with the bridge die BRG in Embodiment 1, in the bridge die BRG in Embodiment 2, disposing of a silicon substrate is omitted, and correspondingly, manufacturing of a through silicon via (TSV) in the silicon substrate is also omitted. A connection requirement can be met only through the through molding via TMV. Manufacturing costs of the through molding via TMV are much lower than those of the TSV. In this way, costs of the bridge die BRG are also reduced.

For another structure part in the bridge die BRG provided in Embodiment 2, refer to the descriptions of the corresponding parts in Embodiment 1. Details are not described herein again.

For example, Embodiment 2 further provides a manufacturing method of the bridge die BRG shown in FIG. 5. As shown in FIG. 6, the manufacturing method may include the following steps.

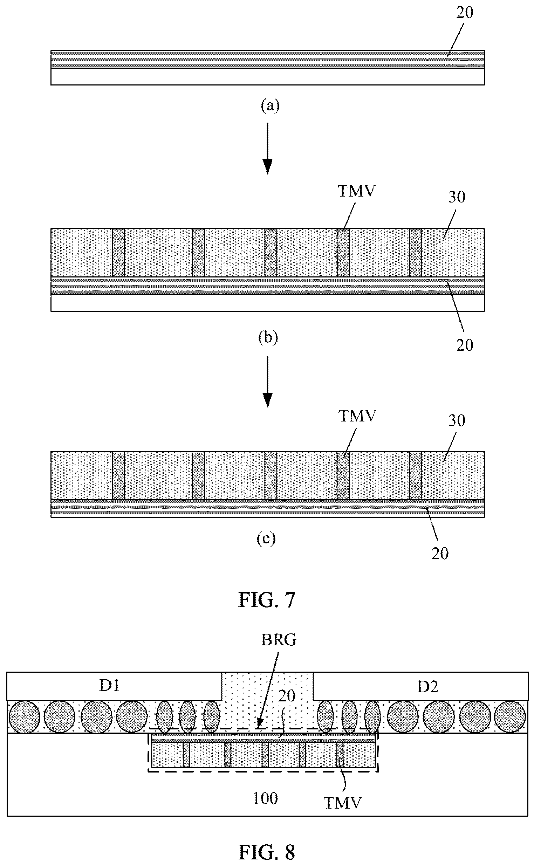

Step 201: Manufacture the metal routing layer 20 as shown in (a) in FIG. 7.

For example, in some possible implementations, as shown in (a) in FIG. 7, the metal routing layer 20 such as the redistribution layer (RDL) may be manufactured on a carrier plate in step 201.

Step 202: As shown in (b) in FIG. 7, form the first molding layer 30 on the metal routing layer 20, form a plurality of through molding vias TMVs in the first molding layer 30, and electrically connect the through molding vias TMVs to the metal routing layer 20.

For example, in some possible implementations, as shown in (b) in FIG. 7, the first molding layer 30 may be formed on the metal routing layer 20 by using a mold compound (for example, PI). Then, a plurality of through molding vias TMVs electrically connected to the metal routing layer 20 are formed in the first molding layer 30 by using a photolithography process and a filling process. Finally, as shown in (c) in FIG. 7, the carrier plate may be removed, to complete manufacturing of the bridge die BRG.

Certainly, as shown in FIG. 5, after the redistribution layer (RDL) is manufactured, a plurality of metal connection structures a may be manufactured in a plurality of die connection regions A on a surface of the redistribution layer (RDL) based on an actual process requirement.

The following describes a chip package structure using the bridge die BRG provided in the foregoing embodiment.

### Package mode 1

As shown in FIG. 8, in some possible implementations, the chip package structure includes a base plate 100, a first die D1, a second die D2, and the bridge die BRG. The first die D1, the second die D2, and the bridge die BRG are molded in a mold compound as a whole.

The bridge die BRG is embedded inside the base plate 100, and a lower surface of the bridge die BRG is electrically connected to the base plate 100 through a through molding via TMV. The first die D1 and the second die D2 are located on a side that is of the bridge die BRG and that is away from the base plate 100, and the first die D1 and the second die D2 are electrically connected to metal connection structures a in different die connection regions A respectively (as shown in FIG. 5).

The first die D1 and the second die D2 are disposed on the base plate 100. In an active surface of the first die D1, a partial region is connected to a metal routing layer 20 of the bridge die BRG, and a partial region is connected to an upper surface of the base plate 100. Similarly, in an active surface of the second die D2, a partial region is connected to the metal routing layer 20 of the bridge die BRG, and a partial region is connected to the upper surface of the base plate 100. In this case, the first die D1 and the second die D2 can be interconnected and communicate with each other through the metal routing layer 20 in the bridge die BRG.

For example, in the package mode 1, the bridge die BRG is embedded into the base plate 100, and an upper surface of the bridge die BRG may be flush with the upper surface of the base plate 100. The first die D1 and the second die D2 are directly connected to the base plate 100 and the bridge die BRG that are located in a same plane.

In practice, a manner of connection between the first die D1 and the bridge die BRG and the base plate 100 and a manner of connection between the second die D2 and the bridge die BRG and the base plate 100 may be set based on a requirement, for example, solder ball connection or copper pillar connection. This is not limited in this application.

### Package mode 2

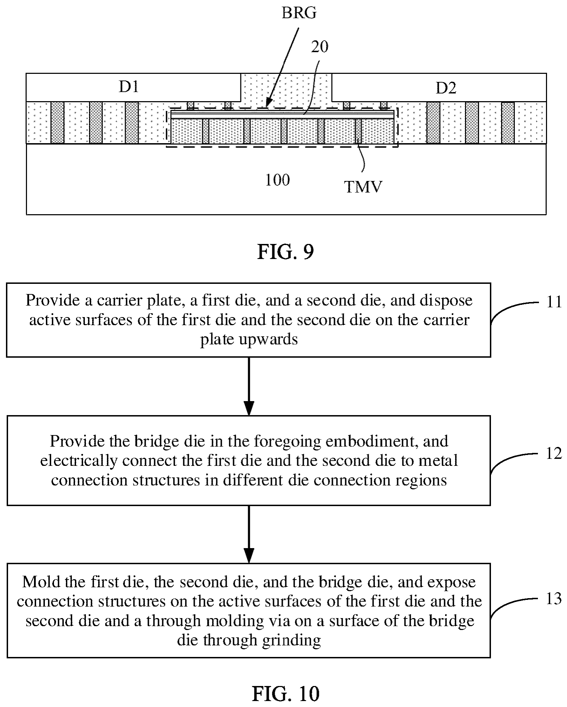

As shown in FIG. 9, in some possible implementations, the chip package structure includes a base plate 100, a first die D1, a second die D2, and a bridge die BRG. The first die D1, the second die D2, and the bridge die BRG are molded in a mold compound as a whole.

The bridge die BRG is disposed on a surface of the base plate 100. A side that is of the bridge die BRG and on which a through molding via TMV is disposed faces the base plate 100, and the bridge die BRG is electrically connected to the base plate 100 through the through molding via TMV. The first die D1 and the second die D2 are located on a side that is of the bridge die BRG and that is away from the base plate 100, and the first die D1 and the second die D2 are electrically connected to metal connection structures a in different die connection regions A respectively (as shown in FIG. 5).

In an active surface of the first die D1, a partial region is electrically connected to the die connection region A of the bridge die BRG, and a partial region is electrically connected to the base plate 100. Similarly, in an active surface of the second die D2, a partial region is electrically connected to the die connection region A of the bridge die BRG, and a partial region is electrically connected to the base plate 100. In this case, the first die D1 and the second die D2 can be interconnected and communicate with each other through the metal routing layer 20 in the bridge die BRG.

A manner of connection between the first die D1 and the base plate 100 and the bridge die BRG is not limited in this application. For example, the first die D1 may be connected to the surface of the base plate 100 through a long connection structure (for example, a long metal pillar), and connected to the metal routing layer 20 of the bridge die BRG through a short connection structure (for example, a short metal pillar).

Similarly, same as disposing of the second die D2, the second die D2 may be connected to the surface of the base plate 100 through a long connection structure (for example, a long copper pillar), and connected to the metal routing layer 20 of the bridge die BRG through a short connection structure (for example, a short copper pillar).

It should be noted that the bridge die BRG in Embodiment 2 is used as an example for illustration in the chip package structures shown in FIG. 8 and FIG. 9. However, this application is not limited thereto. Any bridge die provided in embodiments of this application is applicable to the foregoing two package modes.

A form in which the chip package structure is disposed is not limited in this application. For example, the chip package structure may be a system-on-a-chip (system on a chip, SOC).

A quantity of dies in the chip package structure is not limited in this application, and may be 2, 3, 4, or the like. The first die D1 and the second die D2 may be any two dies in the chip package structure.

For example, an embodiment of this application further provides a manufacturing method of the chip package structure shown in FIG. 9. As shown in FIG. 10, the manufacturing method may include the following steps.

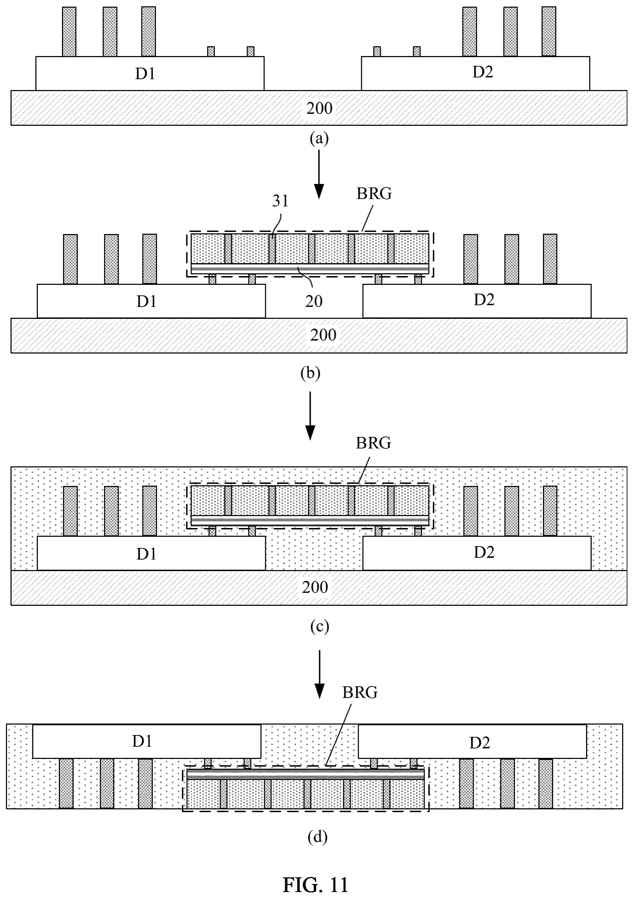

Step 11: As shown in (a) in FIG. 11, provide a carrier plate 200, a first die D1, and a second die D2, and dispose active surfaces of the first die D1 and the second die D2 on the carrier plate 200 upwards.

For example, in some possible implementations, step 11 may include: As shown in (a) in FIG. 11, a wafer (wafer), glass, or the like is provided as the carrier plate 200, and back surfaces of the first die D1 and the second die D2 are pasted to a surface of the carrier plate 200 by using a die attach film (die attach film, DAF) or a thermal release film. In other words, the active surfaces (front surfaces) of the dies (D1 and D2) face upwards.

In addition, connection structures (for example, copper pillars) are disposed on the active surfaces of the first die D1 and the second die D2. A short connection structure may be disposed in an adjacent region of the two dies, for subsequent connection to the bridge die BRG; and a long connection structure may be disposed in another region, for subsequent connection to the base plate 100.

Step 12: As shown in (b) in FIG. 11, provide the bridge die BRG in the foregoing embodiment, and electrically connect the first die D1 and the second die D2 to metal connection structures a in different die connection regions A.

For example, in some possible implementations, step 12 may include: As shown in (b) in FIG. 11, the new bridge die BRG in this embodiment of this application is provided, and the bridge die BRG may be soldered to the first die D1 and the second die D2 by using a flip chip (flip chip, FC) combined with mass reflow (mass reflow, MR) or thermal compression bonding (thermal compression bonding, TCB), to respectively connect metal connection structures a in the two die connection regions A to the short connection structures disposed on surfaces of the first die D1 and the second die D2, so as to implement interconnection between the first die D1 and the second die D2 through the bridge die BRG.

Step 13: As shown in (c) in FIG. 11, mold the first die D1, the second die D2, and the bridge die BRG, and expose the connection structures on the active surfaces of the first die D1 and the second die D2 and a through molding via TMV in a surface of the bridge die BRG through grinding.

For example, in some possible implementations, step 13 may include: As shown in (c) in FIG. 11, molded underfill (molded underfill, MUF) is performed by using a mold compound (mold compound) with a filler size (filler size), and the first die D1, the second die D2, and the bridge die BRG are molded as a whole, to implement physical isolation and chemical protection.

Certainly, in another possible implementation, a region between the bridge die BRG and the dies (D1 and D2) and a region between the first die D1 and the second die D2 may be underfilled (underfill, UF) in step 13, and then, the first die D1, the second die D2, and the bridge die BRG are molded as a whole by using the mold compound (mold compound).

Next, as shown in (d) in FIG. 11, when the dies (D1 and D2) are bonded to the carrier plate 200 through the die attach film (DAF), the carrier plate 200 may be removed through mechanical grinding. When the dies (D1 and D2) are bonded to the carrier plate 200 through the thermal release film, the carrier plate 200 may be removed through mechanical thermal peeling. Finally, the through molding via TMV in the surface of the bridge die BRG and the connection structures on the surfaces of the first die D1 and the second die D2 may be exposed through mechanical grinding.

Certainly, after step 13, as shown in FIG. 9, the molded structure may be connected to the base plate 100 based on an actual requirement. A specific connection manner may be set based on a requirement. This is not limited in this application.

It should be understood that sequence numbers of the foregoing procedures do not mean execution sequences in the manufacturing methods in this application. The execution sequences of the procedures should be determined based on specific functions and internal logic of the procedures, and should not be construed as any limitation on the implementation procedures of embodiments of this application.

In addition, for other related content in the foregoing manufacturing methods, reference may be made to a part in the foregoing corresponding structure embodiment, and details are not described herein again. For another disposing structure in the foregoing structure embodiment, reference may be made to a corresponding manufacturing method and a related manufacturing method for adjustment, and details are not described herein again.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A bridge die, comprising:
a first molding layer, wherein a plurality of through molding vias TMVs are disposed in the first molding layer;
a metal routing layer, wherein the metal routing layer is disposed on the first molding layer, and the metal routing layer is electrically connected to the plurality of TMVs; and
at least two die connection regions, wherein the at least two die connection regions are located on a side that is of the metal routing layer and that is away from the first molding layer, a plurality of first metal connection structures are disposed in each die connection region, and the plurality of first metal connection structures are electrically connected to the metal routing layer.

2. The bridge die according to claim 1, wherein
the first molding layer comprises at least one of resin and polyimide.

3. The bridge die according to claim 1 or 2, wherein
the bridge die further comprises a substrate, and the substrate is located between the metal routing layer and the first molding layer; and
a second metal connection structure is disposed in the substrate, and the metal routing layer is electrically connected to the TMV through the second metal connection structure.

4. The bridge die according to claim 3, wherein
a material of the substrate includes one or more of silicon, glass, silicon nitride, and ceramic.

5. The bridge die according to claim 3 or 4, wherein
a deep trench capacitor is disposed on a surface of a side that is of the substrate and that is close to the metal routing layer, and the deep trench capacitor is electrically connected to the metal routing layer.

6. A chip package structure, comprising a base plate, a first die, a second die, and the bridge die according to any one of claims 1 to 5, wherein
the bridge die is electrically connected to the base plate through the plurality of TMVs; and
the first die and the second die are located on a side that is of the bridge die and that is away from the base plate, and the first die and the second die are electrically connected to first metal connection structures in different die connection regions.

7. A manufacturing method of a bridge die, comprising:
providing a substrate, wherein the substrate comprises a metal connection structure;
manufacturing a metal routing layer on a first surface of the substrate, wherein the metal routing layer is electrically connected to the metal connection structure; and
manufacturing a first molding layer on a second surface of the substrate, forming a plurality of through molding vias TMVs in the first molding layer, and electrically connecting the plurality of TMVs to the metal routing layer through the metal connection structure.

8. A manufacturing method of a bridge die, comprising:
manufacturing a metal routing layer; and
manufacturing a first molding layer on the metal routing layer, forming a plurality of through molding vias TMVs in the first molding layer, and electrically connecting the plurality of TMVs to the metal routing layer.

9. A manufacturing method of a chip package structure, comprising:
providing a carrier plate, a first die, and a second die, and disposing active surfaces of the first die and the second die on the carrier plate upwards;
providing the bridge die according to any one of claims 1 to 5, and electrically connecting the first die and the second die to the two die connection regions of the bridge die respectively; and
molding the first die, the second die, and the bridge die, and exposing the plurality of TMVs and connection structures on the active surfaces of the first die and the second die through grinding.

10. An electronic device, comprising a circuit board and the chip package structure according to claim 6, wherein the chip package structure is electrically connected to the circuit board.
